# EUROPEAN PATENT APPLICATION

(11) **EP 4 761 545 A1**
(43) Date of publication of application: **17.06.2026**
(21) Application number: 23960003.4
(22) Date of filing: 08.12.2023
(51) Int. Cl.: H10K 59/80, H10K 59/122

(54) **DISPLAY PANEL**

(30) Priority: 30.11.2023 CN 202311639971
(71) Applicant: Wuhan China Star Optoelectronics Semiconductor Display Technology Co., Ltd., Wuhan, Hubei 430079 (CN)
(72) Inventor: ZHOU, Jing, Wuhan, Hubei 430079 (CN)
(74) Representative: Zhu, Puxing
(86) International application number: PCT/CN2023/137470
(87) International publication number: WO 2025/112100

(57) **Abstract**

A display panel is provided by the embodiments of the present disclosure. The display panel includes a pixel definition layer, a cladding layer, and a light-emitting layer. The pixel definition layer comprises a black material, and an opening is defined in the pixel definition layer and exposes the pixel electrode. The cladding layer is covered on a side of the pixel electrode away from the substrate and is disposed in the opening. The cladding layer covers at least an edge area of the pixel electrode exposed by the opening. The light-emitting layer is disposed in the opening and covers the cladding layer.

## Description

### TECHNICAL FIELD

The present disclosure relates to a field of display technologies, and in particular to display panels.

### BACKGROUND

In organic light-emitting diode (OLED) panels, red/green/blue resistors correspond to emission of red/green/blue sub pixel units of a light-emitting layer, respectively. A black matrix is used to prevent panel light leakage and reduce panel reflection. To match polarizer-less (PLP) technology and perform low reflection design, a black material is introduced into the pixel definition layer, and the black material has a light absorbing effect due to the presence of pigments, dyes, or carbon black. In the manufacturing process, the pixel definition layer provided with the black material is generally directly patterned using photolithography process. Due to the easy aggregation of the black material and high adhesion at the interface with the anode, the black material is prone to remain in the sub pixel area of the anode. When evaporating the light-emitting layer, it is easy for the light-emitting layer to be punctured by the residue of the black material, causing sub-pixel degradation.

### SUMMARY

The embodiments of the present disclosure provide a display panel that is capable of reducing the risk of a light-emitting layer being punctured by a black residue.

The present embodiment provides a display panel including:
a substrate;
a pixel electrode disposed on the substrate;
a pixel definition layer covered on a surface of the pixel electrode away from the substrate, in which the pixel definition layer includes a black material, an opening is defined in the pixel definition layer, and the opening exposes the pixel electrode;
a cladding layer covered on a side of the pixel electrode away from the substrate and disposed in the opening, in which the cladding layer covers at least an edge area of the pixel electrode exposed by the opening; and
a light-emitting layer, disposed in the opening and covering the cladding layer.

### BRIEF DESCRIPTION OF THE DRAWINGS

FIG. 1 is a structural schematic view of a display panel provided by an embodiment of the present disclosure.
FIG. 2 is another structural schematic view of the display panel provided by an embodiment of the present disclosure.
FIG. 3 is another structural schematic view of the display panel provided by an embodiment of the present disclosure.

### DETAILED DESCRIPTION

The technical solutions in the embodiments of the present disclosure will be described clearly and completely hereinafter with reference to the accompanying drawings. Apparently, the described embodiments are only a part of but not all embodiments of the present disclosure. All other embodiments obtained by those skilled in the art based on the embodiments of the present disclosure without creative efforts shall fall within the protection scope of the present disclosure. In addition, it should be understood that the specific embodiments described herein are merely for illustrating and explaining the present disclosure, and not intended to limit the present disclosure. In the present disclosure, unless stated to the contrary, the used orientation words such as "up" and "down" generally refer to up and down in the actual use or working state of the device, specifically the direction of the drawing in the accompany drawings, and "inside" and "outside" are relative to the outline of the device. The terms "first", "second", "third", etc. are only used as indications and do not impose numerical requirements or establish order.

The embodiments of the present disclosure provide a display panel, which will be described in detail below. It should be noted that the order of description of the following embodiments does not serve as a limitation on the preferred order of embodiments.

The embodiments of the present disclosure provide a display panel including:
a substrate;
a pixel electrode disposed on the substrate;
a pixel definition layer covered on a surface of the pixel electrode away from the substrate, in which the pixel definition layer includes a black material, an opening is defined in the pixel definition layer, and the opening exposes the pixel electrode;
a cladding layer covered on a side of the pixel electrode away from the substrate and disposed in the opening, in which the cladding layer covers at least an edge area of the pixel electrode exposed by the opening; and
a light-emitting layer, disposed in the opening and covering the cladding layer.

Optionally, in some embodiments of the present disclosure, a thickness of the pixel definition layer ranges from 0.8 microns to 2 microns.

Optionally, in some embodiments of the present disclosure, a Young's modulus of the cladding layer ranges from 2 Gpa to 10 Gpa.

Optionally, in some embodiments of the present disclosure, the pixel definition layer includes an opening forming part and a flat part. The opening forming part forms a side wall of the opening. The flat part is adjacent to the opening forming part. The flat part includes a surface flatter than a surface of the opening forming part. The flat part is disposed on a side of the opening forming part away from the opening.

The cladding layer includes a cladding part formed in the opening and a support part formed on the flat part. The cladding part covers at least one side of the opening forming part close to the pixel electrode. The support part includes a raised surface.

Optionally, in some embodiments of the present disclosure, in an area where the opening is located, a distance between an edge of the cladding part and an edge of the opening forming part is less than or equal to 5 microns.

Optionally, in some embodiments of the present disclosure, the cladding layer continuously covers a surface of the pixel definition layer.

Optionally, in some embodiments of the present disclosure, the cladding layer further includes a connecting part, the connecting part is connected to the support part and covered on the flat part, and the connecting part is separated from the cladding part.

Optionally, in some embodiments of the present disclosure, a thickness of the cladding part is less than or equal to 0.2 microns.

Optionally, in some embodiments of the present disclosure, the cladding layer and the pixel definition layer both include organic photosensitive materials, and the cladding layer is a transparent film layer.

Optionally, in some embodiments of the present disclosure, in a plane perpendicular to a board surface of the display panel, a width of the cladding part decreases from a side of the cladding part close to the pixel electrode towards the side of the cladding layer away from the pixel electrode.

Optionally, in some embodiments of the present disclosure, a surface of the cladding part away from the pixel definition layer is a convex surface.

Optionally, in some embodiments of the present disclosure, the display panel further includes an isolation layer. The isolation layer is covered on the surface of the pixel electrode layer away from the substrate. The opening exposes at least a part of the isolation layer. The isolation layer is connected to the pixel definition layer. The isolation layer is configured to separate the black material from the pixel electrode.

An adhesion of the black material to the isolation layer is less than an adhesion of the black material to the pixel electrode.

The cladding layer is disposed in the opening area of the patterned black pixel definition layer in the embodiments of the present disclosure. The cladding layer at least covers the edge area of the pixel electrode exposed by the opening, to wrap the black residue (the black material disposed in the pixel definition layer) remaining in the opening, so that when the light-emitting layer is formed in the opening, the risk of the light-emitting layer being punctured by the black residue is capable of being reduced.

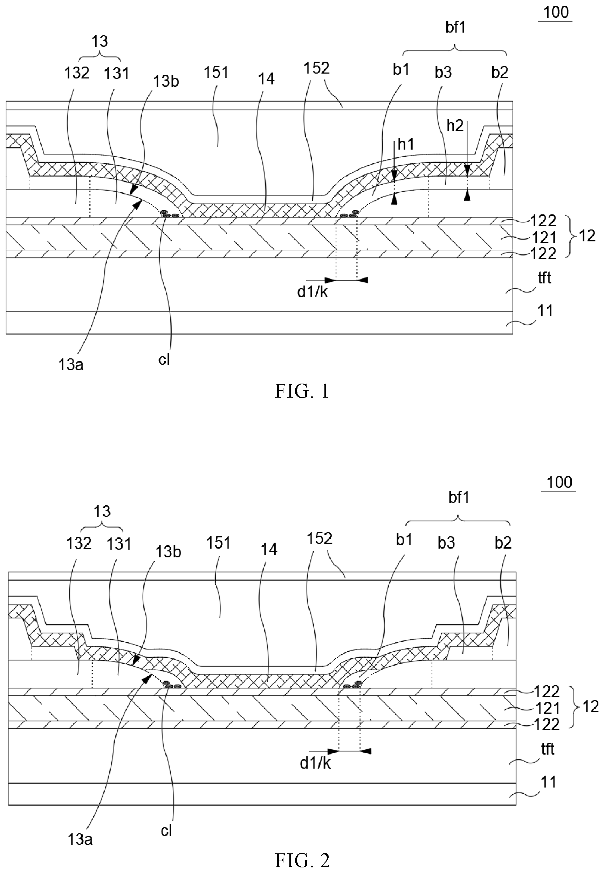

Please refer to FIG. 1, The embodiments of the present disclosures provide the display panel 100, which includes the substrate 11, the pixel electrode 12, the pixel definition layer 13, the cladding layer bf1, and the light-emitting layer 14.

The pixel electrode 12 is disposed on the substrate 11. The pixel definition layer 13 is covered on the surface of the pixel electrode 12 away from the substrate 11. The pixel definition layer 13 includes the black material. The opening 13a is defined in the pixel definition layer 13. The opening 13a exposes the pixel electrode 12.

The cladding layer bf1 is covered on the side of the pixel electrode 12 away from the substrate 11 and is disposed in the opening 13a. The cladding layer bf1 covers at least the edge area of the pixel electrode 12 exposed by the opening 13a, to cover the black material exposed in the opening 13a. The light-emitting layer 14 is disposed in the opening 13a and covers the cladding layer bf1.

Optionally, the pixel definition layer 13 may be formed into organic materials including resins, such as polyacrylates or polyimides, silica, etc. The black material includes but is not limited to materials such as pigments, dyes, or carbon black that have light absorption properties.

In the pixel definition layer 13, the black material is mixed with an organic photosensitive material to form a black organic photosensitive material. Then, the black organic photosensitive material is formed on the substrate 11 and is patterned to form the pixel definition layer 13 using photolithography.

Optionally, the thickness of the pixel definition layer 13 ranges from 0.8 microns to 2 microns. For example, the thickness may be 0.8 microns, 0.9 microns, 1 micron, 1.1 microns, 1.2 microns, 1.3 microns, 1.4 microns, 1.5 microns, 1.6 microns, 1.7 microns, 1.8 microns, 1.9 microns or 2 microns.

If the thickness of the pixel definition layer 13 is lower, its light absorption effect is weaker. If the thickness of the pixel definition layer 13 is too high, the efficiency of the process is lower, the depth of opening 13a is deeper, and the organic packaging layer is less likely to be filled.

Therefore, the thickness limit of the pixel definition layer 13 mentioned above may meet the requirements for light absorption effect, process, and encapsulation, while also reducing the total amount of the black material to a certain extent, thereby reducing the amount of the black residue cl. The black material remaining in the opening 13a is collectively referred to as the black residue cl.

It should be understood that in the process of forming the pixel definition layer, due to the easy aggregation of the black material and high adhesion at the interface with the pixel electrode, the black material is prone to remain on the exposed surface of the pixel electrode in the edge area around the pixel opening.

The display panel 100 of the embodiments of the present disclosure is provided with a cladding layer bf1 in the area where the opening 13a of the patterned black pixel definition layer 13 is located. The cladding layer bf1 is used to wrap the black residue cl (the black material exposed in the opening 13a) that remains inside the opening 13a. Therefore, when the black material is formed in the opening 13a, the risk of the light-emitting layer 14 being punctured by the black residue cl is capable of being reduced.

Optionally, the cladding layer bf1 covers the surrounding edge areas of the opening 13a and is connected to the side wall surface of the opening 13a.

Optionally, the material of the cladding layer bf1 has leveling properties to better wrap the black residue cl. Due to the leveling properties of the material of the cladding layer bf1, the terrain height of the black residue cl is capable of being better reduced or even eliminated, thereby reducing the risk of the light-emitting layer 14 being punctured.

The cladding layer bf1 may be formed into organic materials including resins, such as polyacrylate or polyimide, silica, etc. In the embodiment, the cladding layer bf1 includes an organic photosensitive material, which facilitates the formation of the patterned cladding layer bf1 directly using photolithography process. The cladding layer bf1 is a transparent film layer, which does not contain a black material.

Optionally, a Young's modulus of the cladding layer bf1 ranges from 2 Gpa to 10 Gpa. For example, the Young's modulus of the cladding layer bg1 may be 2 Gpa, 3 Gpa, 4 Gpa, 5 Gpa, 6 Gpa, 7 Gpa, 8 Gpa, 9 Gpa, or 10 Gpa.

It can be understood that the larger the Young's modulus of a film layer is, the smaller its deformation ability is during bending or stress, the greater its stiffness is, and the stronger its ability to resist external forces is. Therefore, the Young's modulus of the cladding layer bf1 is disposed ranging from 2 Gpa to 10 Gpa, which is capable of wrapping the black residue cl while providing high tensile stress for the cladding layer fb1 to meet bending requirements and improve the toughness of the cladding layer bf1 to reduce the risk of the cladding layer fb1 being punctured by the black residue cl.

Optionally, the light-emitting layer 14 may be formed by an organic emitting layer, or formed by a plurality of layers including a hole injection layer (HIL), a hole transport layer (HTL), an organic emitting layer, an electron transport layer (ETL), and an electron injection layer (EIL).

Optionally, the display panel 100 further includes a thin film transistor structure layer TFT and a common electrode layer (not shown in the figure). The thin film transistor structure layer TFT is disposed on the substrate 11. The pixel electrode 12 is disposed on a side of the thin film transistor structure layer TFT away from the substrate 11. The common electrode layer is covered on a side of the light-emitting layer 14 away from the substrate 11.

The pixel electrode 12 may be one of an anode and a cathode, and the common electrode layer may be another one of the anode and the cathode. The pixel electrode 12 may be a single film layer or a plurality of film layer stacked structure.

In the embodiment, the pixel electrode 12 includes a reflection layer 121 and two transparent layers 122. The two transparent layers 122 are disposed on the opposite sides of the reflection layer 121.

A thickness of the reflective layer 121 is greater than the thickness of the transparent layer 122, in order to improve the reflectivity of the pixel electrode 12 at the same thickness.

A material of the reflective layer 121 may include magnesium, silver, gold, calcium, lithium, and aluminum, or one or more metals in their alloys. The transparent layer 122 is formed from materials such as indium tin oxide, indium zinc oxide, zinc oxide, or indium oxide.

Optionally, the pixel definition layer 13 includes the opening forming part 131 and the flat part 132 adjacent to the opening forming part 131. The opening forming part 131 forms the side wall of the opening 13a.

The cladding layer bf1 includes the cladding part b1 formed in the opening 13a and a support part b2 formed on the flat part 132. The cladding part b1 covers at least a side of the opening forming part 131 close to the pixel electrode 12. The support part b2 has a raised surface.

The embodiment adopts a cladding layer bf1 to simultaneously form a support part b2 and a cladding part b1, saving one photomask process.

In some embodiments, the cladding layer bf1 may be formed by two processes. That is to say, the cladding part b1 and the support part b2 are each formed by a photomask. In addition, the material of the cladding part b1 may be different from the material of the support part b2.

Optionally, in the area where the opening 13a is located, the distance d1 between the edge of the cladding part b1 and the edge of the opening forming part 131 is less than or equal to 5 microns. The distance d1 may be 5 microns, 4 microns, 3 microns, 2 microns, or 1 micron.

It can be understood that due to the lack of the pixel definition layer 13 below the area between the edge of the wrapping part b1 and the edge of the opening forming part 131, the reflection intensity of light in the area is relatively high. So, the distance of the area is limited to be less than or equal to 5 microns to limit the reflection area of the area within a small range, thereby reducing the reflection effect of the display panel 100 when the screen is turned off.

Optionally, the distance d1 between the edge of the cladding part b1 and the edge of the opening forming part 131 is greater than or equal to 1 micron, so that the cladding layer bf1 covers the area with more black residue cl.

Optionally, the cladding layer bf1 further includes the connecting part b3. The connecting part b3 is connected to the support part b2. The connecting part b3 is covered on the flat part 132.

The connecting part b3 is connected to the support part b2 and attached to the flat part 132 of the pixel definition layer 13, reducing the risk of detachment between the support part b2 and the pixel definition layer 13.

Optionally, the cladding part b1 fully covers the opening forming part 131. The connecting part b3 is connected to the cladding part b1. That is, the cladding layer bf1 continuously covers the surface of the pixel definition layer 13.

The cladding part b1 fully covers the opening forming part 131, so that the light-emitting layer 14 has a smoother formation interface in the area where the opening 13a is located, improving the continuity of the light-emitting layer 14 in the area where the opening 13a is located. In addition, it also reduces the risk of peeling off the cladding layer bf1, that is, the connection stability of the cladding layer bf1 is improved.

Optionally, in some embodiments, referring to FIG. 2, the cladding part b1 is covered on a side of the opening forming part 131 close to the pixel electrode 12. The connecting part b3 is separated from the cladding part b1.

Compared to the embodiment where the cladding part b1 is connected to the connecting part b3, the corresponding embodiment in FIG. 2 only involves separating the cladding part b1 from the connecting part b3.

In the area where the opening 13a is located, since there is only a pixel definition layer 13, after overlaying the connection part b3 on the pixel definition layer 13, the depth of the area where the opening 13a is located is the thickness of the pixel definition layer 13. The depth is shallower, making it easier for subsequent organic encapsulation layer to level and fill the area where the opening 13a is located.

Furthermore, based on the surface of the pixel electrode 12 away from the substrate 11, the maximum height of the cladding part b1 separated from the connection part b3 is smaller than the maximum height of the opening forming part 131, so that the depth of the opening 13a area is equal to the thickness of the opening forming part 131.

Optionally, the display panel 100 further includes an organic encapsulation layer 151 covered on a side of the light-emitting layer 14 away from the substrate 11. The organic encapsulation layer 151 fills the opening 13a.

The thickness h1 of the cladding part b1 is less than or equal to 0.2 microns. The thickness h2 of the connecting part b3 is greater than the thickness h1 of the cladding part b1.

The thickness h1 of the cladding part b1 is limited to be less than or equal to 0.2 microns, to avoid causing the depth of the corresponding area 13a to be too deep after the cladding part b1 overlaps with the opening forming part 131, thereby facilitating the organic encapsulation layer 151 to level and fill the area where the opening 13a is located, and improving encapsulation performance.

Optionally, the thickness h1 of the cladding part b1 may be 0.2 microns, 0.15 microns, 0.1 microns, or 0.05 microns.

The thickness h2 of the connecting part b3 is greater than the thickness h1 of the cladding part b1, which is capable of improving the stability of the connection between the connecting part b3 and the flat part 132. In addition, since the connecting part b3 is correspondingly attached to the area where the flat part 132 is located, the thickness of the connecting part b3 is larger and does not affect the depth of the area where the opening 13a is located.

Optionally, the thickness h2 of the connecting part b3 is less than or equal to 1 micron, such as 1 micron, 0.9 micron, 0.8 microns, 0.7 microns, 0.6 microns, 0.5 microns, 0.4 microns, 0.3 microns, or 0.2 microns.

It should be noted that the display panel 100 may further include two inorganic encapsulation layers 152. The two inorganic encapsulation layers 152 and the organic encapsulation layer 151 are alternately stacked. One inorganic encapsulation layer 152 is covered on a side of a common electrode layer away from the substrate 11, the organic encapsulation layer 151 is covered on a side of the inorganic encapsulation layer 152 away from the substrate 11, and another inorganic encapsulation layer 152 is covered on a side of the organic encapsulation layer 151 away from the substrate 11.

Optionally, the organic encapsulation layer 151 is formed from a polymer and may be a laminated layer or a single layer, such as formed from any one of polyethylene terephthalate, polyimide, polycarbonate, epoxy resin, polyethylene, and polyacrylate. The organic encapsulation layer 151 may be formed from polyacrylates, specifically including substances obtained by polymerization of monomer compositions including diacrylate-based monomers and triacrylate-based monomers. The monomer composition may further include monoacrylate-based monomers. In addition, the monomer composition may further include well-known photoinitiators such as diphenyl(2,4,6-trimethylbenzoyl)phosphine oxide (TPO), but the monomer composition is not limited to this. The inorganic encapsulation layer 152 may be a laminated layer or a single layer including metal oxides or metal nitrides, such as any one of SiNₓ, Al₂O₃, SiO₂, and TiO₂.

Optionally, the thickness h1 of the cladding part b1 is greater than or equal to 0.1 microns, so that the cladding part b1 may wrap the black residue cl to a large extent.

Optionally, in a plane perpendicular to a board surface of the display panel 100, a width k of the cladding part b1 decreases from a side of the cladding part b1 close to the pixel electrode 12 towards a side of the cladding layer b1 away from the pixel electrode 12.

The maximum width k of the cladding part b1 is the distance d1 between the edge of the cladding layer bf1 and the edge of the opening forming part 131.

The cladding part b1 with width gradient may improve the smoothness of the area where the opening 13a is located while meeting the requirements for wrapping the black residue cl, facilitating the leveling of the organic encapsulation layer 151.

Optionally, in the plane perpendicular to a board surface of the display panel 100, the surface of the cladding part b1 away from the pixel definition layer 13 is a convex surface. This setting further improves the smoothness of the area where the opening 13a is located and allows the cladding part b1 to warp more black residue cl in the area whose width is the distance d1, thereby reducing the risk of the light-emitting layer 14 being punctured.

In some embodiments, the surface of the cladding part b1 away from the pixel definition layer 13 may be an inclined surface or a concave surface.

Optionally, the display panel 100 may further include a color film layer. The color film layer is covered on a side of the inorganic encapsulation layer 152 away from the substrate 11. The color film layer includes a black matrix layer. A plurality of hollow openings are defined in the black matrix layer, and a plurality of color resistances are disposed in the hollow openings. The color resistances and the openings 13a are disposed one-to-one. In an orthogonal projection pattern of the display panel 100, a distance between a center of the hollow opening and a center of the opening 13a is less than or equal to 1 micron.

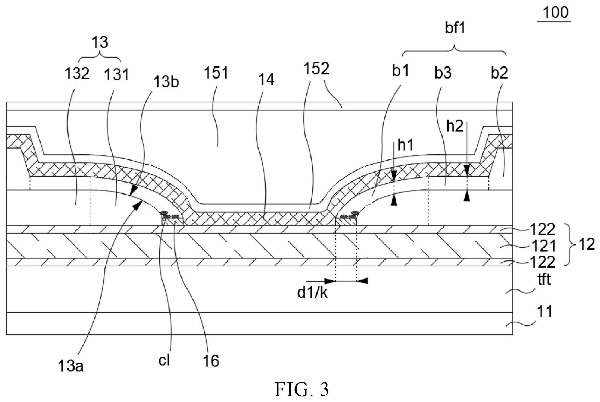

Optionally, referring to FIG. 3, in some embodiments, based on the above embodiments, the display panel 100 further includes an isolation layer 16. The isolation layer 16 is covered on the surface of the pixel electrode 12 away from the substrate 11. The opening 13a exposes at least a part of the isolation layer 16. The isolation layer 16 is connected to the pixel definition layer 13. The isolation layer 16 is used to separate the black material from the pixel electrode 12.

An adhesion of the black material to the isolation layer 16 is smaller than an adhesion of the black material to the pixel electrode 12.

The setting of the isolation layer 16 reduces the adhesion of the black material, thereby increasing the success rate of removing residual black material in the development stage, and thereby reducing the amount of black residue cl.

It should be noted that the magnitude of adhesion may be measured by the hundred grid method or the pull-up method.

Optionally, the material of the isolation layer 16 may include an oleophobic material to reduce the adhesion of the black material to the isolation layer 16.

Optionally, the isolation layer 16 is fully exposed in the opening 13a. In some embodiments, a part of the isolation layer 16 extends between the pixel definition layer 13 and the pixel electrode 12.

The cladding layer is disposed in the opening area of the patterned black pixel definition layer in the embodiments of the present disclosure. The cladding layer wraps the black residue (the black material disposed in the pixel definition layer) remaining in the opening, so that when the light-emitting layer is formed in the opening, the risk of the light-emitting layer being punctured by the black residue is capable of being reduced.

The display panel provided in the embodiments of the present disclosure are described in detail above. The principle and implementations of the present disclosure are described in this specification by using specific examples. The description about the foregoing embodiments is merely provided to help understand the method and core ideas of the present disclosure. In addition, those skilled in the art can make modifications in terms of the specific implementations and application scopes according to the ideas of the present disclosure. Therefore, the content of this specification shall not be construed as a limit to the present disclosure.

## Claims

1. A display panel, comprising:
a substrate;
a pixel electrode disposed on the substrate;
a pixel definition layer covered on a surface of the pixel electrode away from the substrate, wherein the pixel definition layer comprises a black material, one or more openings are defined in the pixel definition layer, and the opening exposes the pixel electrode;
a cladding layer covered on a side of the pixel electrode away from the substrate and disposed in the opening, wherein the cladding layer covers at least an edge area of the pixel electrode exposed by the opening; and
a light-emitting layer, disposed in the opening and covering the cladding layer.

2. The display panel of claim 1, wherein the pixel definition layer comprises an opening forming part and a flat part, the opening forming part forms a side wall of the opening, the flat part is adjacent to the opening forming part, the flat part comprises a surface flatter than a surface of the opening forming part, and the flat part is disposed on a side of the opening forming part away from the opening; and
the cladding layer comprises a cladding part formed in the opening and a support part formed on the flat part, the cladding part covers at least one side of the opening forming part close to the pixel electrode, and the support part comprises a raised surface.

3. The display panel of claim 2, wherein in an area where the opening is located, a distance between an edge of the cladding part and an edge of the opening forming part is less than or equal to 5 microns.

4. The display panel of claim 2, wherein the cladding layer continuously covers a surface of the pixel definition layer.

5. The display panel of claim 2, wherein the cladding layer further comprises a connecting part, the connecting part is connected to the support part and covered on the flat part, and the connecting part is separated from the cladding part.

6. The display panel of claim 4, wherein a thickness of the cladding part is less than or equal to 0.2 microns.

7. The display panel of claim 6, wherein the thickness of the cladding part is greater than or equal to 0.1 microns.

8. The display panel of claim 6, wherein the cladding layer further comprises a connecting part connected to the cladding part, the connecting part is connected to the support part and covered on the flat part, and a thickness of the connecting part is greater than the thickness of the cladding part.

9. The display panel of claim 8, wherein the thickness of the connecting part is less than or equal to 1 micron.

10. The display panel of claim 1, wherein the cladding layer and the pixel definition layer both comprise organic photosensitive materials, and the cladding layer is a transparent film layer.

11. The display panel of claim 1, wherein a Young's modulus of the cladding layer ranges from 2 Gpa to 10 Gpa.

12. The display panel of claim 2, wherein in a plane perpendicular to a board surface of the display panel, a width of the cladding part decreases from a side of the cladding part close to the pixel electrode towards a side of the cladding layer away from the pixel electrode.

13. The display panel of claim 12, wherein a surface of the cladding part away from the pixel definition layer is a convex surface.

14. The display panel of claim 2, wherein a surface of the cladding part away from the pixel definition layer is an inclined surface or a concave surface.

15. The display panel of claim 1, wherein a thickness of the pixel definition layer ranges from 0.8 microns to 2 microns.

16. The display panel of claim 1, wherein the display panel comprises a organic encapsulation layer and two inorganic encapsulation layers, the two inorganic encapsulation layers and the organic encapsulation layer are alternately stacked, one of the two inorganic encapsulation layers is covered on a side of the light-emitting layer away from the substrate, the organic encapsulation layer is covered on a side of the one of the two inorganic encapsulation layers away from the substrate, and another one of the two inorganic encapsulation layers is covered on a side of the organic encapsulation layer away from the substrate.

17. The display panel of claim 16, wherein the display panel further comprises a color film layer, the color film layer is covered on a side of the another one of the two inorganic encapsulation layers away from the substrate, the color film layer comprises a black matrix layer, a plurality of hollow openings are defined in the black matrix layer, a plurality of color resistances are disposed in the hollow openings, the color resistances and the openings are disposed one-to-one, and in an orthographic projection pattern of the display panel, a distance between a center of one of the hollow openings and a center of one of the openings is less than or equal to 1 micron.

18. The display panel of claim 1, wherein the pixel electrode comprises a reflective layer and two transparent layers, the transparent layers are disposed on opposite sides of the reflective layer, and a thickness of the reflective layer is greater than a thickness of the transparent layer.

19. The display panel of claim 1, wherein the display panel further comprises an isolation layer, the isolation layer is covered on the surface of the pixel electrode layer away from the substrate, the opening exposes at least a part of the isolation layer, the isolation layer is connected to the pixel definition layer, and the isolation layer is configured to separate the black material from the pixel electrode; and
an adhesion of the black material to the isolation layer is less than an adhesion of the black material to the pixel electrode.

20. The display panel of claim 19, wherein a material of the isolation layer comprises an oleophobic material.
